# EUROPEAN PATENT APPLICATION

(11) **EP 2 688 110 A1**
(43) Date of publication of application: **22.01.2014**
(21) Application number: 12758291.4
(22) Date of filing: 28.02.2012
(51) Int. Cl.: H01L 31/04

(54) **SOLAR CELL AND SOLAR CELL MODULE**

(30) Priority: 17.03.2011 JP 2011058759
(71) Applicant: Sanyo Electric Co., Ltd., Osaka 570-8677 (JP)
(72) Inventor: NISHIWAKI, Takeshi, Moriguchi-shi Osaka 570-8677 (JP); TAIRA, Shigeharu, Moriguchi-shi Osaka 570-8677 (JP); YOSHIMINE, Yukihiro, Moriguchi-shi Osaka 570-8677 (JP)
(74) Representative: Glawe, Delfs, Moll
(86) International application number: PCT/JP2012/054865
(87) International publication number: WO 2012/124463

(57) **Abstract**

A solar cell and solar module with improved moisture resistance are provided. A solar cell (10) is provided with a photoelectric conversion unit (20), an n-side electrode (21b), and a p-side electrode (21a). The photoelectric conversion unit (20) has an n-type surface and a p-type surface. The n-side electrode (21b) is connected electrically to the n-type surface. The p-side electrode (21a) is connected electrically to the p-type surface. The amount of Na in each of the n-side electrode (21b) and the p-side electrode (21 a) is 20 ppm or less.

## Description

### FIELD OF THE INVENTION

The present invention relates to a solar cell and solar module.

### BACKGROUND OF THE INVENTION

The solar module is provided with solar cells. The solar cells have a photoelectric conversion unit, and an n-side electrode and p-side electrode arranged on the photoelectric conversion unit. The solar cells are arranged between a front surface protecting member and a back surface protecting member. A bonding layer fills space between the front surface protecting member and the back surface protecting member. The solar cells are sealed in the bonding layer.

Various studies have been conducted to improve the moisture resistance of such solar modules. One example is described in Patent Document 1.

### Cited Documents

### Patent Documents

Patent Document 1: Laid-Open Patent Publication No. 2008-235603

### SUMMARY OF THE INVENTION

### Problem Solved by the Invention

In recent years, there has been even greater desire for improved moisture resistance in solar modules.

In view of this situation, it is an object of the present invention to provide a solar cell and solar module with improved moisture resistance.

### Means of Solving the Problem

A solar cell in the present invention is provided with a photoelectric conversion unit, an n-side electrode, and a p-side electrode. The photoelectric conversion unit has an n-type surface and a p-type surface. The n-side electrode is connected electrically to the n-type surface. The p-side electrode is connected electrically to the p-type surface. The amount of Na in each of the n-side electrode and the p-side electrode is 20 ppm or less.

The solar module in the present invention is provided with a first protecting member, a second protecting member, a bonding layer, and a solar cell. The bonding layer fills space between the first protecting member and the second protecting member. The solar cell is arranged in the bonding layer. The solar cell has a photoelectric conversion unit, an n-side electrode, and a p-side electrode. The photoelectric conversion unit has an n-type surface and a p-type surface. The n-side electrode is connected electrically to the n-type surface. The p-side electrode is connected electrically to the p-type surface. The amount of Na in each of the n-side electrode and the p-side electrode is 20 ppm or less.

### Effect of the Invention

The present invention is able to provide a solar cell and solar module with improved moisture resistance.

### BRIEF DESCRIPTION OF THE DRAWINGS

FIG. 1 is a schematic cross-sectional view of a solar module in an embodiment.
FIG. 2 is a schematic plan view of the first main surface of the solar cell in an embodiment.
FIG. 3 is a schematic transparent plan view of the second main surface of the solar cell in an embodiment.
FIG. 4 is a schematic transparent view of the back surface of the solar cell in a variation.
FIG. 5 is a graph showing the open circuit voltage (Voc) of the solar cell in an example and in a comparative example.
FIG. 6 is a graph showing the fill factor (F.F.) of the solar cell in an example and in a comparative example.

### DETAILED DESCRIPTION OF THE INVENTION

The following is an explanation of a preferred embodiment of the present invention. The following embodiments are merely examples. The present invention is not limited to the following embodiments in any way.

Further, in each of the drawings referenced in the embodiments, members having substantially the same function are denoted by the same symbols. The drawings referenced in the embodiments are also depicted schematically. The dimensional ratios of the objects depicted in the drawings may differ from those of the actual objects. The dimensional ratios of objects may also vary between drawings. The specific dimensional ratios of the objects should be determined with reference to the following explanation.

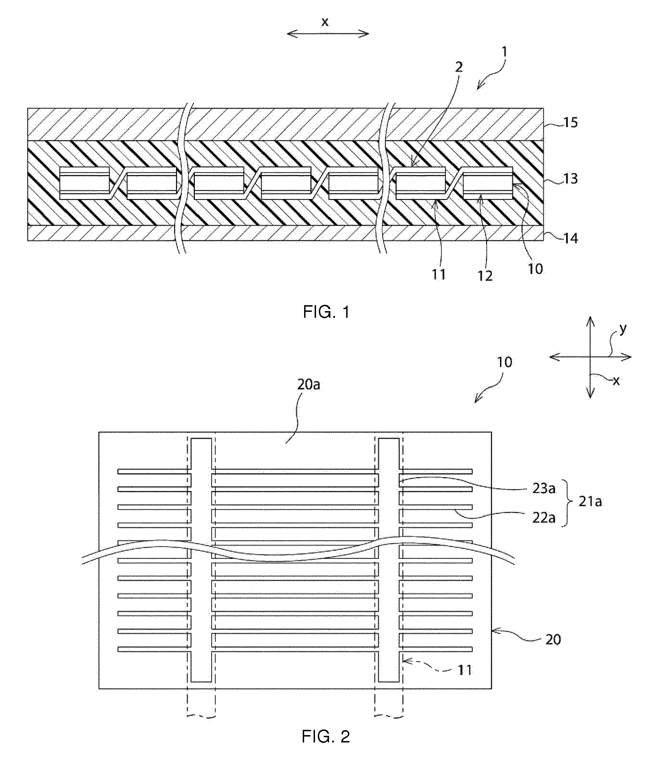

FIG. 1 is a schematic cross-sectional view of a solar module in an embodiment.

A solar module 1 is provided with at least one solar cell string 2. A solar cell string 2 has a plurality of solar cells 10. In a solar cell string 2, the solar cells 10 are arranged in the x direction. The solar cells 10 are connected electrically to each other by wiring member 11.

A transparent member 15 is arranged on the light-receiving surface of the solar cell string 2. A weather-resistant member 14 is arranged on the back surface of the solar cell string 2. A bonding layer 13 fills space between the transparent member 15 and the weather-resistant member 14. The solar cells 10 are sealed by the bonding layer 13. A terminal box for extracting the power generated by the solar cells 10 is attached to the surface of the weather-resistant member 14.

The transparent member 15 is composed of a transparent glass plate or plastic plate. The weather-resistant member 14 is composed of a resin sheet that does not contain a metal film. The water vapor transmission rate (WVTR) of the weather-resistant member 14 is 0.01 g/m²·day or greater. The resin sheet constituting the weather-resistant member 14 can be, for example, a resin sheet made with polyester resin, or a resin sheet such as PVF made with PET or a fluororesin.

In the present embodiment, the water vapor transmission rate is the amount of permeated water per unit area over the course of one day at 40°C and a relative humidity of 90%. The water vapor transmission rate can be measured using the Mocon method.

There are no particular limits on the constituent materials of the bonding layer 13. The bonding layer 13 can include, for example, a resin selected from a group comprising ethylene-vinyl acetate (EVA) copolymers, and polyolefin resins such as polyethylene and polypropylene.

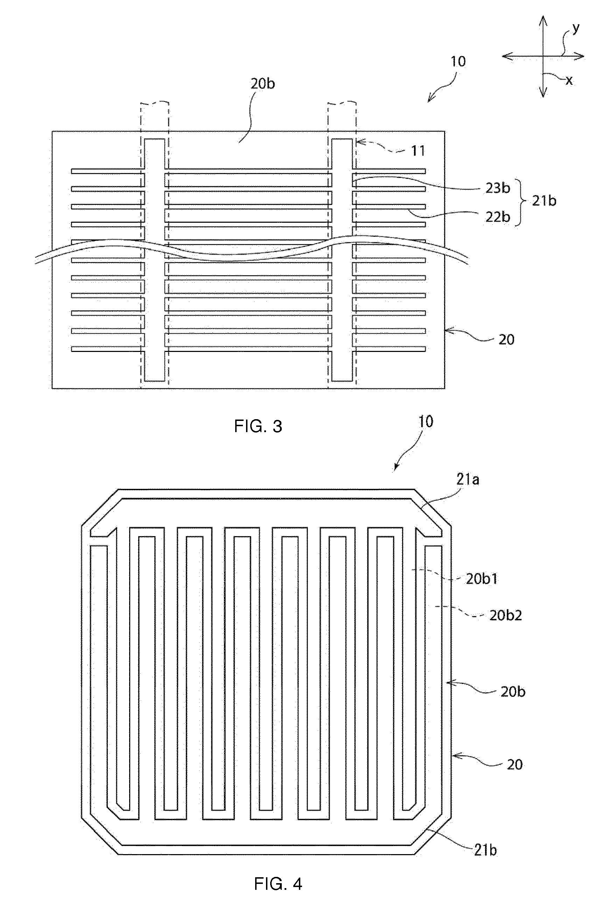

FIG. 2 is a schematic plan view of the first main surface of the solar cell in the embodiment. FIG. 3 is a schematic transparent plan view of the second main surface of the solar cell in the embodiment.

A solar cell 10 has a photoelectric conversion unit 20. The photoelectric conversion unit 20 generates carriers (electrons and holes) by receiving light. There are no particular restrictions on the photoelectric conversion unit 20. For example, it can have a crystalline semiconductor substrate of one type of conductivity, and a semiconductor layer of the other type arranged on the semiconductor substrate. The photoelectric conversion unit 20 may have a diffusion region in which a dopant of one type of conductivity is diffused in a semiconductor substrate having the other type of conductivity, a compound semiconductor layer, or a thin-film semiconductor as a light-absorbing layer. In other words, the solar cell 10 can be composed of a crystalline silicon solar cell, thin-film silicon solar cell, or compound semiconductor cell.

The photoelectric conversion unit 20 has a first main surface 20a and a second main surface 20b. In the photoelectric conversion unit 20, either the first main surface 20a or the second main surface 20b faces the transparent member 15, and the other surface faces the weather-resistant member 14. In the present embodiment, the first main surface 20a is a p-type surface. The surface of a transparent conductive film provided on the p-type surface may also be a constituent of the first main surface 20a. A p-side electrode 21a containing metal is arranged on the first main surface 20a. The p-side electrode 21a is connected electrically to the p-type surface.

The second main surface 20b is a n-type surface. The surface of the transparent conductive film provided on the n-type surface may also be a constituent of the second main surface 20b. A n-side electrode 21b containing metal is arranged on the second main surface 20b. The n-side electrode 21b is connected electrically to the n-type surface.

Either one of the p-side electrode 21a and n-side electrode 21b has an area smaller than the other electrode. The electrode with the smaller area is arranged facing the transparent member 15. By reducing the area of the electrode arranged on the side with the transparent member 15, the amount of light incident on the photoelectric conversion unit 20 can be increased.

Either one of the p-side electrode 21a and n-side electrode 21b includes a conductive layer formed using conductive paste. When an electrode is formed on the surface of a transparent conductive film using conductive paste, a conductive resin paste can be used to suppress deformation of the transparent conductive film. Because transparent conductive film is superior in terms of carrier collection, a solar cell using transparent conductive film has improved photoelectric conversion properties. The other electrode may be formed using conductive paste, or may be formed using a PVD method such as a deposition or sputtering method.

In the present embodiment, the electrodes 21a, 21b have a plurality of finger portions 22a, 22b and a plurality of busbar portions 23a, 23b, respectively. An electrode including a plurality of finger portions and busbar portions is formed with a screen printing method using conductive paste. The screen printing method using conductive paste is industrially superior. The electrode on the side with the weather-resistant member 14 may be arranged so as to cover nearly all of the main surface on the photoelectric conversion unit.

Each of the finger portions 22a, 22b extend parallel to each other in the y direction, which is perpendicular to the x direction. The finger portions 22a, 22b are arranged parallel to each other separated by a predetermined distance in the x direction, which is perpendicular to the y direction. The finger portions 22a, 22b are connected electrically to the busbar portions 23a, 23b. The busbar portions 23a, 23b are formed in the x direction.

The number of finger portions 22a, 22b arranged on the side with the transparent member 15 is smaller than the number of finger portions arranged on the other side. This reduces the area of the electrode arranged on the side with the transparent member 15.

In the present embodiment, the amount of Na in each of the p-side electrode 2 1 a and the n-side electrode 21b is 20 ppm or less. Preferably, the amount of Na in each of the p-side electrode 21a and the n-side electrode 21b is less than 10 ppm

The amount of Na in an electrode can be measured in the following way. First, the electrode is removed from the solar cell using a utility knife. Next, 0.25 g of the cutaway sample material is placed in 10 mL of a solution obtained by mixing together nitric acid and hydrogen peroxide at a weight ratio of 9:1, and the sample is dissolved in the solution using a microwave-assisted wet digestion device. The solution is then diluted by adding water to obtain a volume of 50 mL, and a sample is obtained for measurement. ICP emission spectrometric analysis is performed on this sample to detect the amount of Na. The detected amount of Na is then divided by 0.25 g to determine the amount of Na contained in the electrode.

ICP emission spectrometric analysis can be performed on the sample at a measurement wavelength of 588.995 nm using a Seiko Instruments SPS4000.

The p-side electrode 21 a of one solar cell 10 and the n-side electrode 21b of the adjacent solar cell 10 are connected electrically in the x direction using wiring member 11.

There are no particular restrictions on the wiring member 11 as long as it is conductive. For example, the wiring member 11 can be composed of a wiring body and a coating layer covering the wiring body. The wiring body can be formed from a low-resistance metal such as Cu. The coating layer can be formed from a metal such as Ag, solder, or an alloy.

The wiring member 11 and solar cells 10 are bonded using solder or a resin adhesive. In other words, the wiring member 11 and the solar cells 10 are bonded using an adhesive layer 12 comprising solder or a cured resin adhesive.

The resin adhesive is preferably a thermosetting resin. Examples of thermosetting resins include epoxy resins, phenoxy resins, acrylic resins, polyimide resins, polyamide resins, and polycarbonate resins. These thermosetting resins can be used alone or in combinations of two or more.

The resin adhesive may have conductive or insulating properties. When the resin adhesive has conductive properties, the resin adhesive may be a resin adhesive with anisotropic conductive properties and contain a conductive material. Specific examples include particles of a metal such as nickel, copper, silver, aluminum, tin or gold, or particles of an alloy of one or more of these metals. Another example is insulating particles with a conductive coating such as a metal coating or alloy coating.

When the resin adhesive has insulating properties and does not contain a conductive material, the wiring member 11 and a solar cell 10 may be connected electrically by bringing the wiring member 11 and the solar cell 10 into direct contact before bonding them together using the resin adhesive.

### Manufacturing Method for Solar Module 1

The following is an explanation of a method for manufacturing the solar module 1. First, the photoelectric conversion unit 20 is prepared. A predetermined pattern is applied on the first main surface 20a and the second main surface 20b of the photoelectric conversion unit 20 by screen printing a conductive paste containing conductive particles such as silver particles, and then curing or firing the conductive paste to form the p-side electrode 21 a and n-side electrode 21b. This completes the solar cell 10.

Next, a plurality of solar cells 10 are connected electrically using wiring member 11. This creates a solar cell string 2. Then at least one solar cell string 2 is sealed between the transparent member 15 and the weather-resistant member 14 using a bonding layer 13. More specifically, a resin sheet such as an EVA sheet is placed on the transparent member 15. The solar cell string 2 is placed on the resin sheet. A resin sheet such as an EVA sheet is then placed on thereupon, and a weather-resistant member 14 is further placed thereupon. These components are subjected to heat and pressure in a reduced pressure atmosphere and laminated to create a solar cell panel. If necessary, a terminal box may be attached to the surface of the weather-resistant member 14, and a frame attached to the peripheral edges of the panel to complete the solar module 1.

In order to improve the insulating properties of the weather-resistant member 14, the weather-resistant member 14 may be constituted from a resin sheet containing no metal film. This increases the water vapor transmission rate of the weather-resistant member 14. For this reason, moisture readily infiltrates into the bonding layer 13 via the weather-resistant member 14. This increases the water content of the bonding layer 13. When the water content of the bonding layer 13 increases, the Na in the p-side electrode and n-side electrode readily diffuses into the bonding layer 13. When Na diffuses into the bonding layer 13, the Na concentration of the bonding layer 13 rises. As a result, the Na in the bonding layer 13 causes the photoelectric conversion unit 20 containing the semiconductor member to deteriorate, causing the properties of the solar cell to deteriorate.

In the present embodiment, the Na content of each of the p-side electrode 21a and the n-side electrode 21b is 20 ppm or less. As a result, the Na concentration of the bonding layer 13 is less likely to increase even when there is moisture in the bonding layer 13. Thus, the photoelectric conversion unit 20 does not deteriorate. Therefore, the properties of the solar cell 10 are unlikely to deteriorate. In other words, the solar module 1 in the present embodiment has improved weather-resistant properties.

In order to further improve the weather-resistant properties, the Na content of each of the p-side electrode 21a and the n-side electrode 21b is preferably less than 10 ppm.

In particular, in a solar cell in which at least one electrode out of the p-side electrode 21 a and the n-side electrode 21b is formed using conductive paste, when the p-side electrode 21a and the n-side electrode 21b have an Na content of 20 ppm or less, and preferably less than 10 ppm, , a solar cell and solar module can be provided with superior productivity and improved weather-resistant characteristics.

Further, in a solar cell in which at least one electrode out of the p-side electrode 21a and the n-side electrode 21b is formed on the surface of a transparent conductive film using conductive paste, when the p-side electrode 21a and the n-side electrode 21b have an Na content of 20 ppm or less, and preferably less than 10 ppm, a solar cell and solar module can be provided with superior productivity, excellent photoelectric conversion properties, and improved weather-resistant characteristics.

The weather-resistant characteristics can be improved by restricting the Na content of both the p-side electrode 21a and the n-side electrode 21b, irrespective of the constituent materials of the transparent member 15, the weather-resistant member 14, and the bonding layer 13. However, in the present embodiment, at least the weather-resistant member 14 is made of a resin sheet containing no metal film. The effect is further strengthened when the water vapor transmission rate is greater than 0.01 g/m²·day, and the bonding layer 13 is a water permeable material such as an ethylene-vinyl acetate copolymer.

The present invention includes many other embodiments not described herein. For example, as shown in FIG. 4, the solar cell 10 may have a p-type surface 20b1 and an n-type surface 20b2 on the second main surface 20b, and the p-side electrode 2 1 a and the n-side electrode 21b may be connected to the second main surface 20b to obtain a back contact solar cell without an electrode on the first main surface 20a.

The p-side electrode and the n-side electrode may also be so-called busbarless electrodes with finger portions only. Either the p-side electrode or n-side electrode may also have a planar electrode portion arranged over the entirety of one of the main surfaces of the photoelectric conversion unit 20.

The solar module may also contain only one solar cell.

Both the weather-resistant member and the transparent member may be metal-free resin sheets, and the water vapor transmission rate may be 0.01 g/m²·day or greater.

The present invention includes various other embodiments not described herein. Therefore, the technical scope of the present invention is defined solely by the items specified in the claims pertinent to the above explanation.

### Example and Comparative Example

In an example, a solar cell was prepared in which the p-side electrode and n-side electrode were formed using a conductive resin paste, and the amount of Na in each of the p-side electrode and the n-side electrode was 18 ppm.

In a comparative example, a solar cell was prepared in which the p-side electrode and n-side electrode were formed using a conductive resin paste, and the amount of Na in each of the p-side electrode and the n-side electrode was 72 ppm.

### Evaluation of Moisture Resistance

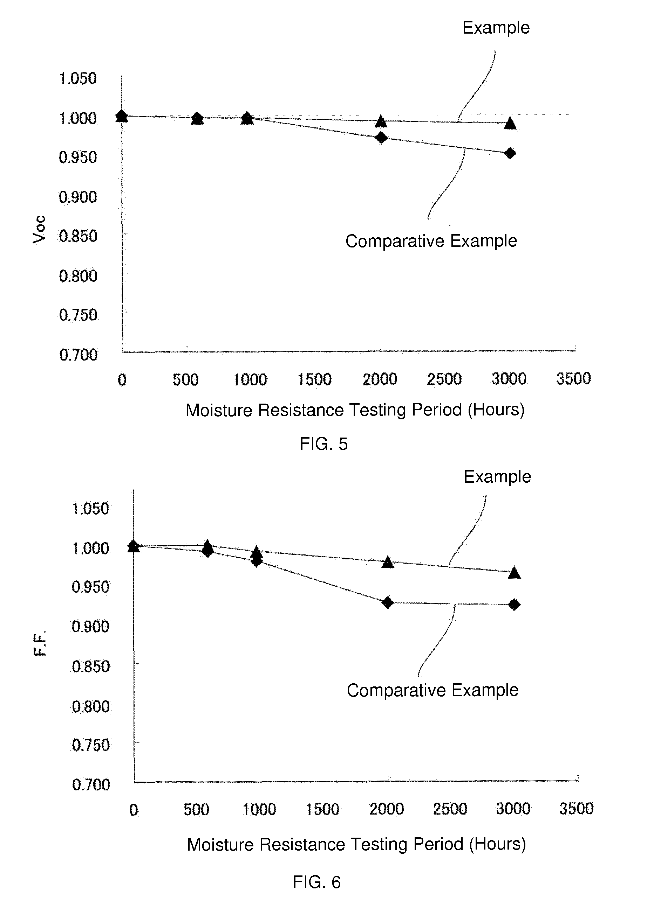

The open circuit voltage (Voc) and fill factor (F.F.) of the solar cells in the example and in the comparative example were measured while held in the atmosphere 85°C with a relative humidity of 85%. FIG. 5 is a graph showing the measured open circuit voltage (Voc) where the open circuit voltage (Voc) before the test (time = 0 hours) was set at 1. FIG. 6 is a graph showing the measured fill factors (F.F.) where the fill factor (F.F.) before the test (time = 0 hours) was set at 1.

It is clear from FIG. 5 and FIG. 6 that the moisture resistance of the solar cell in the example of the present invention, having an Na content of 18 ppm in the p-side electrode and the n-side electrode, was superior to the moisture resistance of the solar cell in the comparative example, having an Na content of 72 ppm in the p-side electrode and the n-side electrode.

### Key to the Drawings

1: Solar module
2: Solar cell string
10: Solar cell
11: Wiring member
12: Adhesive layer
13: Bonding layer
14: Weather-resistant member
15: Transparent member
20: Photoelectric conversion unit
20a: First main surface
20b1: p-type surface
20b2: n-type surface
20b: Second main surface
21a: p-side electrode
21b: n-side electrode
22a, 22b: Finger portions
23a, 23b: Busbar portions

## Claims

1. A solar cell comprising:
a photoelectric conversion unit having an n-type surface and a p-type surface,
an n-side electrode connected electrically to the n-type surface, and
a p-side electrode connected electrically to the p-type surface;
the amount of Na in each of the n-side electrode and the p-side electrode being 20 ppm or less.

2. The solar cell according to claim 1, wherein the amount of Na in each of the n-side electrode and the p-side electrode is less than 10 ppm.

3. The solar cell according to claim 1 or claim 2, wherein at least one electrode among the n-side electrode and the p-side electrode has a finger portion formed from conductive paste.

4. The solar cell according to claim 1 or claim 2, wherein at least one electrode among the n-side electrode and the p-side electrode has a finger portion formed from conductive paste on the surface of a transparent conductive film.

5. A solar module comprising:
a first protecting member,
a second protecting member,
a bonding layer filling space between the first protecting member and the second protecting member,
and a solar cell arranged inside the bonding layer;
the solar cell having:
a photoelectric conversion unit having an n-type surface and a p-type surface,
an n-side electrode connected electrically to the n-type surface, and
a p-side electrode connected electrically to the p-type surface; and
the amount of Na in each of the n-side electrode and the p-side electrode being 20 ppm or less.

6. The solar module according to claim 5, wherein the amount of Na in each of the n-side electrode and the p-side electrode is less than 10 ppm.

7. The solar module according to claim 5 or claim 6, wherein at least one electrode among the n-side electrode and the p-side electrode has a finger portion formed from conductive paste.

8. The solar module according to claim 5 or claim 6, wherein at least one electrode among the n-side electrode and the p-side electrode has a finger portion formed from conductive paste on the surface of a transparent conductive film.

9. The solar module according to any one of claims 5 through 8, wherein at least one of the first or the second protecting members is formed from a resin sheet containing no metal film.

10. The solar module according to any one of claims 5 through 9, wherein the water vapor transmission rate of at least one of the first or the second protecting members is 0.01 g/m²·day or greater.

11. The solar module according to any one of claims 5 through 10, wherein the bonding layer includes at least one type of resin selected from a group comprising ethylene-vinyl acetate (EVA) copolymers, polyethylene, and polypropylene.
